# EUROPEAN PATENT APPLICATION

(11) **EP 4 752 563 A1**
(43) Date of publication of application: **03.06.2026**
(21) Application number: 24845657.6
(22) Date of filing: 24.07.2024
(51) Int. Cl.: G01R 1/067, G01R 1/073, G01R 31/26

(54) **PROBE**

(30) Priority: 26.07.2023 JP 2023121770
(71) Applicant: Kabushiki Kaisha Nihon Micronics, Musashino-shi Tokyo 180-8508 (JP)
(72) Inventor: NASU Mika, Musashino-shi, Tokyo 180-8508 (JP)
(74) Representative: Samson & Partner Patentanwälte mbB
(86) International application number: PCT/JP2024/026506
(87) International publication number: WO 2025/023282

(57) **Abstract**

A probe includes: a tip member that has a support portion; and a base material in which a joint region is formed by retracting a portion of a side surface in a thickness direction perpendicular to an axial direction within a certain range along the axial direction from one end. A first side surface of the support portion of the tip member and a retracted opposed side surface of the base material exposed in the joint region abut against each other, and the tip member and the base material are joined together. A convex portion that projects in the thickness direction is formed on one of the first side surface and the opposed side surface, and a concave portion that fits with the convex portion is formed on the other of the first side surface and the opposed side surface.

## Description

### TECHNICAL FIELD

The present invention relates to a probe used for inspecting the electrical characteristics of an inspection object.

### BACKGROUND ART

In order to inspect the electrical characteristics of an inspection object, such as a semiconductor integrated circuit, in a wafer state, an electrical connection apparatus including a probe is used. In inspection using a probe, one end portion of the probe is brought into contact with an electrode pad of the inspection object, and the other end portion of the probe is brought into contact with a terminal (hereinafter, referred to as "land") disposed on a printed circuit board or the like. The land is electrically connected to an inspection device such as a tester.

### CITATION LIST

### PATENT LITERATURE

Patent Literature 1: Japanese Patent Application Publication No. 2007-147518

### SUMMARY OF INVENTION

### PROBLEMS TO BE SOLVED BY INVENTION

In order to suppress wear of the end portion of the probe due to contact with an inspection object, the probe is used in which a tip member made of a hard material having a hardness higher than a base material is joined to one end of the base material with a column-like shape, for example. An object of the present invention is to provide a probe in which the tip member is prevented from being detached from the base material.

### SOLUTION TO SOLVE PROBLEMS

An aspect of the present invention is to provide a probe including: a tip member that has a support portion; and a base material in which a joint region is formed by retracting a portion of a side surface in a thickness direction perpendicular to an axial direction within a certain range along the axial direction from one end. A first side surface of the support portion of the tip member and a retracted side surface of the base material exposed in the joint region abut against each other, and the tip member and the base material are joined together. A convex portion that projects in the thickness direction is formed on one of the first side surface and the retracted side surface, and a concave portion that fits with the convex portion is formed on the other of the first side surface and the retracted side surface.

### EFFECTS OF INVENTION

According to the present invention, it is possible to provide a probe in which a tip member is prevented from being detached from a base material.

### BRIEF DESCRIPTION OF DRAWINGS

[FIG. 1] FIG. 1 is a schematic cross-sectional view illustrating a configuration of a probe according to a first embodiment of the present invention.
[FIG. 2] FIG. 2 is a schematic perspective view illustrating the configuration of the probe according to the first embodiment of the present invention.
[FIG. 3] FIG. 3 is a schematic view illustrating a configuration of an electrical connection apparatus using the probes according to the first embodiment of the present invention.
[FIG. 4] FIG. 4 is a schematic view illustrating a state in which the probe according to the first embodiment of the present invention and an inspection object are in contact with each other.
[FIG. 5] FIG. 5 is a schematic cross-sectional view illustrating a configuration of a probe according to a modified example of the first embodiment of the present invention.
[FIG. 6A] FIG. 6A is a schematic cross-sectional view illustrating a configuration of a convex portion and a concave portion of the probe according to the modified example of the first embodiment of the present invention.
[FIG. 6B] FIG. 6B is a schematic cross-sectional view illustrating another configuration of a convex portion and a concave portion of the probe according to the modified example of the first embodiment of the present invention.
[FIG. 7] FIG. 7 is a schematic cross-sectional view illustrating a configuration of a probe according to a second embodiment of the present invention.
[FIG. 8] FIG. 8 is a schematic cross-sectional view illustrating a configuration of a probe according to a third embodiment of the present invention.
[FIG. 9] FIG. 9 is a schematic cross-sectional view illustrating a configuration of a probe according to a modified example of the third embodiment of the present invention.
[FIG. 10] FIG. 10 is a schematic view illustrating a configuration of a probe according to another embodiment of the present invention.

### DESCRIPTION OF EMBODIMENTS

Next, embodiments of the present invention will be described below with reference to the drawings. The same or similar elements illustrated in the drawings are denoted by the same or similar reference numerals. However, the drawings are illustrated schematically, and it should be noted that the proportions of the thicknesses or lengths of the respective parts and so forth are not drawn to scale. It should also be understood that the relationships or proportions of the dimensions between the respective drawings are different from each other in some elements. The embodiments described below exemplify a device and a method for embodying a technical idea of the present invention. In the embodiments of the present invention, the material, shape, structure, arrangement, manufacturing method and the like of the components are not limited to the following description.

### (First embodiment)

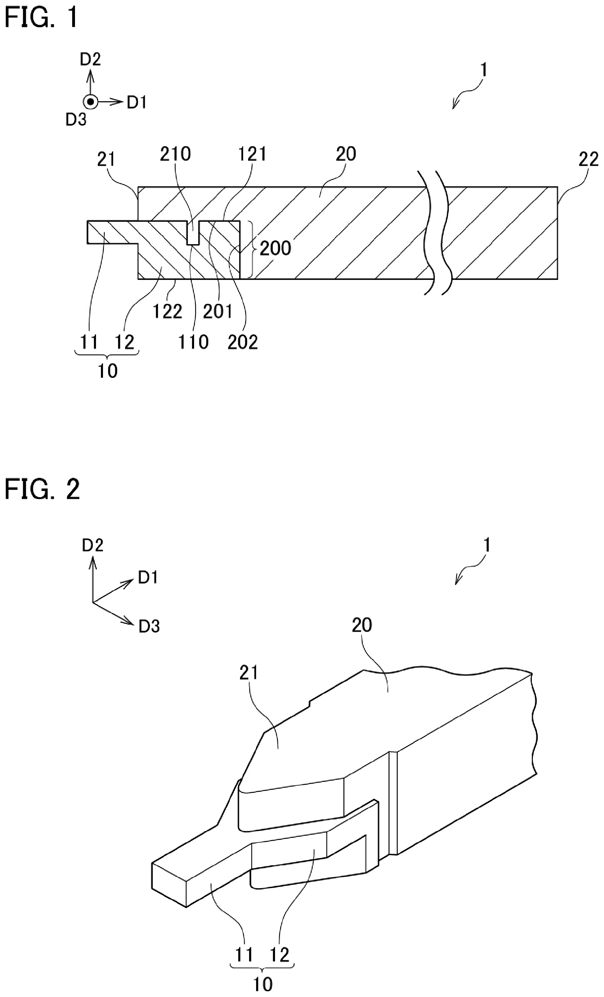

A probe 1 according to a first embodiment illustrated in FIG. 1 is used for inspecting the electrical characteristics of an inspection object. The probe 1 includes a tip member 10 and a base material 20. The tip member 10 has a projection portion 11 configured to be in contact with the inspection object and a support portion 12 coupled to the projection portion 11. The tip member 10 is joined to the base material 20 at the support portion 12. FIG. 1 is a cross-sectional view taken along the central axis of the probe 1.

As illustrated in FIGS. 1 and 2, a direction in which the base material 20 with a column-like shape extends is defined as an axial direction D1, a direction perpendicular to the axial direction D1 and in which the support portion 12 and the base material 20 face each other is defined as a thickness direction D2, and a direction perpendicular to the axial direction D1 and the thickness direction D2 is defined as a width direction D3.

A joint region 200 is formed in the base material 20 by retracting a portion of the side surface in the thickness direction D2 within a certain range along the axial direction D1 from one end (hereinafter also referred to as "first end portion 21"). The joint region 200 is a space generated by retracting a portion of the side surface of the base material 20 toward the central axis, and the retracted side surface is exposed in the joint region 200. As illustrated in FIG. 1, the support portion 12 is disposed so as to be fitted into the joint region 200. The retracted side surface that faces the support portion 12 is also referred to as an "opposed side surface 201" in the following description.

The support portion 12 of the tip member 10 is disposed in the joint region 200 such that the projection portion 11 projects from the first end portion 21 of the base material 20. More specifically, the first side surface 121 of the support portion 12 of the tip member 10 and the opposed side surface 201 of the base material 20 exposed in the joint region 200 abut against each other. A convex portion that projects in the thickness direction D2 is formed on one of the first side surface 121 and the opposed side surface 201, and a concave portion that fits with the convex portion is formed on the other of the first side surface 121 and the opposed side surface 201.

FIG. 1 exemplarily illustrates a configuration in which a convex portion 210 is formed on the opposed side surface 201 and a concave portion 110 is formed on the first side surface 121. The convex portion may be formed on the first side surface 121 and the concave portion may be formed on the opposed side surface 201. In the configuration illustrated in FIG. 1, the abutting surface between the convex portion and the concave portion formed at the interface between the first side surface 121 and the opposed side surface 201 has a rectangular shape formed by the sides parallel and perpendicular to the axial direction D1 in the cross section along the axial direction D1.

Of the plurality of side surfaces of the support portion 12 parallel to the axial direction D1, only the first side surface 121 abuts against the base material 20. In addition, the end surface of the support portion 12 that faces the opposite direction from the projection portion 11 abuts against the end surface (hereinafter also referred to as "opposed end surface 202") of the base material 20 exposed in the joint region 200. The second side surface 122 of the support portion 12 that faces in the opposite direction of the first side surface 121 is continuous with the side surface of the base material 20 without a step.

The materials of the tip member 10 and the base material 20 may be selected such that the conductivity of the tip member 10 is equal to or higher than that of the base material 20. By selecting the materials of the tip member 10 and the base material 20 in this manner, the electrical resistance of the probe 1 can be reduced. For example, the material of the tip member 10 may be rhodium (Rh), platinum (Pt), or other noble metals. The base material 20 may be nickel (Ni), a nickel alloy, gold (Au), silver (Ag), copper (Cu), palladium (Pd), a palladium alloy, rhodium (Rh), a rhodium alloy, or other noble metals. The tip member 10 and the base material 20 may be joined by a bonding material such as a gold (Au) material.

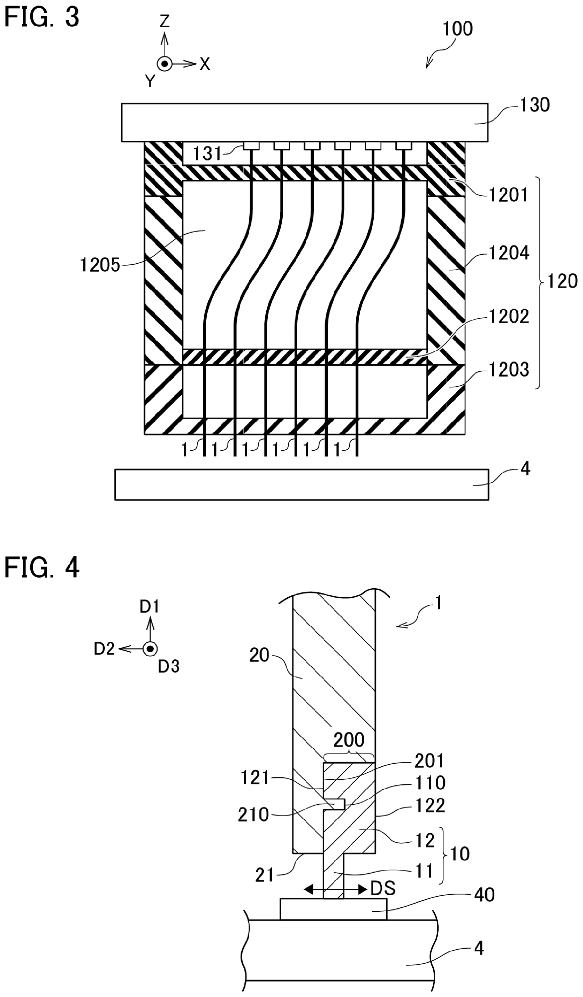

The probe 1 illustrated in FIG. 1 is used in the electrical connection apparatus 100 illustrated in FIG. 3, for example. In the electrical connection apparatus 100, the probe 1 is held by a probe head 120. Specifically, a plurality of probes 1 are inserted sequentially through the respective guide holes of the first guide plate 1201, the second guide plate 1202 and the third guide plate 1203 included in the probe head 120 and held by the probe head 120. In the following, the first guide plate 1201, the second guide plate 1202, and the third guide plate 1203 are collectively referred to as guide plates when not specifically distinguished. The probe head 120 has a configuration in which the first guide plate 1201, the second guide plate 1202 and the third guide plate 1203 as a plurality of guide plates are arranged so as to be separated from each other in the surface normal direction (Z direction) of the main surfaces of the guide plates. In the probe head 120, a spacer 1204 is disposed between the outer edge region of the first guide plate 1201 and the outer edge region of the third guide plate 1203 in order to form a hollow region 1205 between the first guide plate 1201 and the second guide plate 1202. The second guide plate 1202 is disposed closer to the third guide plate 1203 within the hollow region 1205. The material of the probe head 120 is, for example, ceramic.

Upon the inspection of an inspection object 4, the electrical connection apparatus 100 moves relative to the inspection object 4 along the Z direction, and the tip member 10 of the probe 1 comes into contact with the inspection object 4. FIG. 3 illustrates a state in which the probe 1 and the inspection object 4 are separated from each other. The second end portion 22 of the base material 20 comes into contact with the land 131 of the substrate 130. The land 131 is electrically connected to an inspection device such as an IC tester (not illustrated). As the projection portion 11 of the probe 1 comes into contact with the inspection object 4, the inspection object 4 and the inspection device are electrically connected to each other.

As illustrated in FIG. 3, regarding the guide holes through which the same probe 1 penetrates, the position of the guide hole of the first guide plate 1201 is shifted in the -X direction, which is parallel to the main surface of the second guide plate 1202, with respect to the guide hole of the second guide plate 1202. FIG. 3 is a side view as seen from the Y direction orthogonal to both the X direction and the Z direction. Hereinafter, an arrangement in which the positions of the guide holes are shifted is referred to as an "offset arrangement". Further, a direction in which the positions of the guide holes are shifted is also referred to as an "offset direction." In FIG. 3, the offset direction is the -X direction. Due to the offset arrangement, the base material 20 of the probe 1 is curved within the probe head 120. That is, the base material 20 is curved due to elastic deformation in the hollow region 1205 between the first guide plate 1201 and the second guide plate 1202. The positions of the guide holes of the second guide plate 1202 and the positions of the guide holes of the third guide plate 1203 coincide with each other when viewed from the Z direction.

Since the guide holes of the first guide plate 1201 and the guide holes of the second guide plate 1202 are arranged in an offset manner, the probe 1 buckles in the hollow region 1205 when the probe 1 comes into contact with the inspection object 4. That is, in the contact state where the probe 1 is in contact with the inspection object 4, the probe 1 is further curved due to deflection deformation from the curved shape in the non-contact state in which the probe 1 is not in contact with the inspection object 4. As the probe 1 is further curved, the probe 1 comes into contact with the inspection object 4 at a predetermined pressure. Therefore, the electrical characteristics of the inspection object 4 can be stably measured using the probe 1 by the offset arrangement. The probe 1 has elasticity to return to the shape before contact with the inspection object 4 when entering the non-contact state.

Upon the inspection of the inspection object 4, the projection portion 11 of the tip member 10 projecting from the first end portion 21 of the base material 20 comes into contact with the electrode 40 disposed on the inspection object 4, for example, as illustrated in FIG. 4. After the projection portion 11 comes into contact with the electrode 40, the position of the projection portion 11 is displaced in the direction parallel to the surface of the electrode 40 by the pressing force that presses the probe 1 against the inspection object 4. Meanwhile, after the inspection of the inspection object 4 is finished, the position of the projection portion 11 is displaced in the direction opposite to the direction at the start of the inspection while remaining in contact with the inspection object 4 until changing to the non-contact state. The direction in which the position of the projection portion 11 is displaced while remaining in contact with the inspection object 4 is referred to as the "scrubbing direction DS" as illustrated in FIG. 4. The scrubbing direction DS coincides with the offset direction. In other words, the scrubbing direction DS is a direction in which the probe 1 can be curved.

As described above, the tip member 10 and the base material 20 are joined such that the support portion 12 and the base material 20 have an overlap in a direction in which the probe 1 can be curved. In other words, as illustrated in FIG. 4, the support portion 12 of the tip member 10 and the base material 20 overlap each other in the scrubbing direction DS.

As the tip member 10 moves while remaining in contact with the inspection object 4, a stress along the scrubbing direction DS is generated in the joint portion between the tip member 10 and the base material 20, and thus the tip member 10 is easily detached from the base material 20. Further, upon the inspection of the inspection object 4, a load such as a pressing force along the axial direction D1 is applied to the joint portion between the tip member 10 and the base material 20. Therefore, with an increase in the number of contacts between the inspection object 4 and the probe 1, the bonding strength of the joint material which joins the tip member 10 and the base material 20 decreases, and thus the tip member 10 is easily detached from the base material 20. As the number of probes 1 arranged in the electrical connection apparatus 100 increases, the cost required for replacing the probes 1 due to the tip member 10 being detached from the base material 20 cannot be negligible.

In contrast, in the probe 1, since the convex portion and the concave portion formed at the interface between the first side surface 121 of the support portion 12 and the opposed side surface 201 of the base material 20 fit together, the tip member 10 is prevented from being detached from the base material 20. That is, since the protrusion direction of the convex portion and the hollow direction of the concave portion are formed in the thickness direction D2, the concave-convex shape functions as a stopper for preventing the tip member 10 from being detached from the base material 20.

Further, the concave-convex shape formed at the interface between the first side surface 121 of the support portion 12 and the opposed side surface 201 of the base material 20 also functions as a restricting portion for restricting positional displacement between the tip member 10 and the base material 20 when the probe 1 comes into contact with the inspection object 4.

Further, in the probe 1, the support portion 12 of the tip member 10 and the base material 20 overlap each other along the scrubbing direction DS. In other words, in a direction in which the position of the projection portion 11 in contact with the inspection object 4 is displaced when starting to inspect the inspection object 4, the tip member 10 and the base material 20 are joined such that the support portion 12 and the base material 20 have an overlap. Therefore, the projection direction of the convex portion formed at the interface between the first side surface 121 and the opposed side surface 201 is the direction in which the position of the projection portion 11 is displaced. For this reason, even if a stress in the scrubbing direction DS is generated in the joint portion between the tip member 10 and the base material 20, the tip member 10 is hardly detached from the base material 20.

As described above, in the probe 1 according to the first embodiment, the tip member 10 and the base material 20 are joined at the interface between the first side surface 121 of the support portion 12 and the opposed side surface 201 of the base material 20 as the concave portion fits with the convex portion that projects in the thickness direction D2 perpendicular to the axial direction D1. Therefore, according to the probe 1, the tip member 10 joined to one end of the base material 20 can be prevented from being detached from the base material 20.

In the present invention, regarding the thickness direction D2, the support portion 12 is joined to the base material 20 only at the first side surface 121. Therefore, compared with a configuration in which the tip member 10 is joined to the base material 20 at two side surfaces so as to be surrounded by the base material 20, for example, the joint area between the support portion 12 and the base material 20 along the thickness direction D2 can be increased. In other words, the area of the support portion 12 that is joined to the opposed end surface 202 of the base material 20 can be increased. Thus, the electrical resistance at the joint surface between the support portion 12 and the base material 20 can be reduced.

As illustrated in FIG. 2, the first end portion 21 of the base material 20 that overlaps the support portion 12 when viewed from the thickness direction D2 and the support portion 12 may have a tapered shape in which the width gradually increases from the first end portion 21 along the axial direction D1 when viewed from the thickness direction D2. By forming the support portion 12 and the first end portion 21 into a tapered shape, it becomes easier to insert the probe 1 into the guide holes of the guide plates during the assembly of the electrical connection apparatus 100.

### <Modified example>

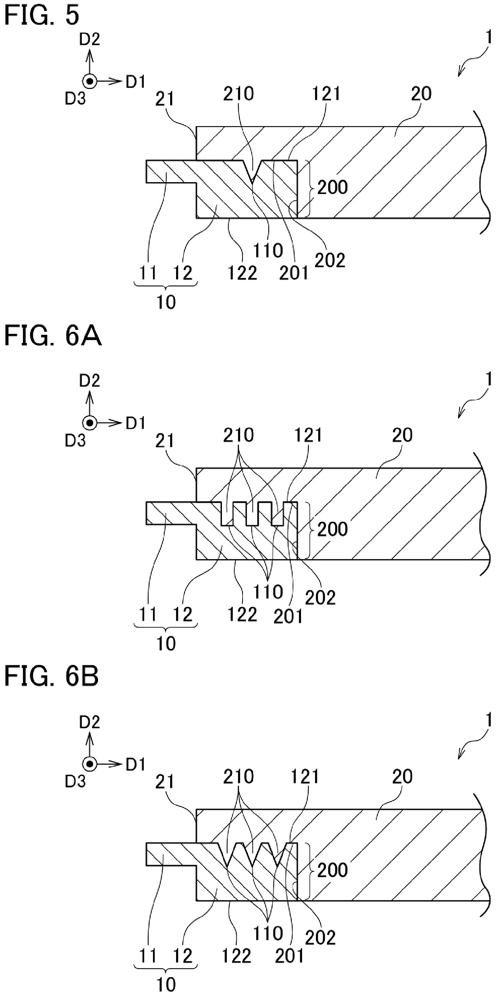

As illustrated in FIG. 5, the abutting surface between the convex portion and the concave portion may have a tapered shape formed by the sides obliquely intersecting the axial direction D1 in the cross section along the axial direction D1. In other words, even if the abutting surface between the convex portion and the concave portion has a shape other than a rectangular shape, the convex portion and the concave portion fit together in the thickness direction D2, thereby preventing the tip member 10 from being detached from the base material 20.

Further, although the above example illustrates a case where one pair of the convex portion and the concave portion is formed at the interface between the first side surface 121 of the support portion 12 and the opposed side surface 201 of the base material 20, a plurality of convex portions and a plurality of concave portions that respectively fit with the plurality of convex portions may be formed at the interface between the first side surface 121 and the opposed side surface 201. By forming the multiple pairs of the convex portions and the concave portions, it is possible to further prevent the tip member 10 from being detached from the base material 20. The pairs of the convex portions and the concave portions may be arranged in the axial direction D1. For example, as illustrated in FIG. 6A, a plurality of convex portions and concave portions having rectangular abutting surfaces may be formed at the interface between the first side surface 121 and the opposed side surface 201. Alternatively, as illustrated in FIG. 6B, a plurality of convex portions and concave portions having tapered abutting surfaces may be formed at the interface between the first side surface 121 and the opposed side surface 201.

Although FIG. 5 and FIGS. 6A and 6B illustrate a configuration in which the convex portion 210 is formed on the opposed side surface 201 and the concave portion 110 is formed on the first side surface 121, a convex portion may be formed on the first side surface 121 and a concave portion may be formed on the opposed side surface 201. Alternatively, a convex portion and a concave portion may be formed on the opposed side surface 201, and a concave portion and a convex portion that respectively fit with them may be formed on the first side surface 121.

### (Second embodiment)

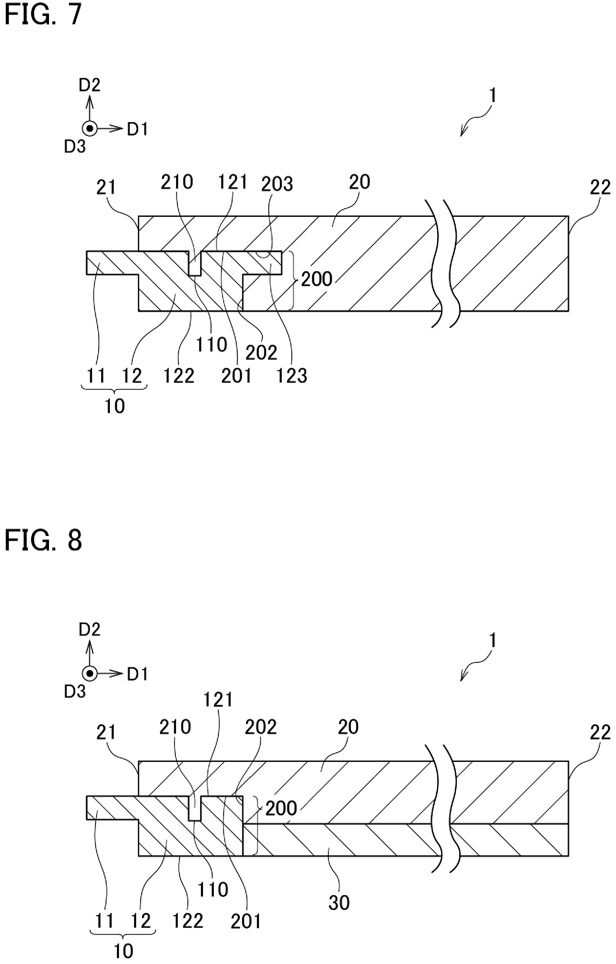

In the probe 1 according to the second embodiment, as illustrated in FIG. 7, an embedded portion 123 is formed in the support portion 12 of the tip member 10, and an embedded groove 203 is formed in the opposed end surface 202 of the base material 20. The embedded portion 123 extends along the axial direction D1, which is opposite to the direction in which the projection portion 11 projects. The embedded groove 203 is formed in the opposed end surface 202 of the base material 20 that faces the support portion 12 in the axial direction D1. The embedded portion 123 of the support portion 12 is embedded in the embedded groove 203 of the base material 20. The other configurations of the probe 1 according to the second embodiment are the same as those of the first embodiment illustrated in FIG. 1.

In the probe 1 illustrated in FIG. 7, the support portion 12 has a region surrounded by the concave-convex shape of the interface between the first side surface 121 and the opposed side surface 201 and the concave-convex shape of the interface between the support portion 12 and the opposed end surface 202. This region functions as a stopper for preventing the tip member 10 from being detached from the base material 20. Therefore, according to the probe 1 illustrated in FIG. 7, the holding strength of the tip member 10 by the base material 20 can be further increased. Furthermore, in the probe 1 illustrated in FIG. 7, since the embedded portion 123 is embedded in the embedded groove 203, the joint area between the support portion 12 and the base material 20 is increased. Therefore, according to the probe 1 illustrated in FIG. 7, the tip member 10 is further prevented from being detached from the base material 20 during an inspection of the inspection object 4.

In other respects, the probe 1 according to the second embodiment is substantially the same as the first embodiment, and overlapping descriptions are omitted. For example, a convex portion may be formed on the first side surface 121 and a concave portion may be formed on the opposed side surface 201. Further, the abutting surface between the convex portion and the concave portion may be tapered, or multiple pairs of the convex portions and the concave portions may be formed.

### (Third embodiment)

As illustrated in FIG. 8, the probe 1 according to the third embodiment includes a transmission member 30, which is disposed on the side surface of the base material 20 extending in the axial direction D1 from the end of the joint region 200. The transmission member 30 may be made of a material having a lower electrical resistance than the base material 20. The end surface of the support portion 12 of the tip member 10 that faces the axial direction D1 is connected to the end surface of the transmission member 30 that faces the axial direction. The probe 1 illustrated in FIG. 8 differs from the first embodiment in that it includes the transmission member 30. The other configurations of the probe 1 according to the third embodiment are the same as those of the first embodiment illustrated in FIG. 1.

In the probe 1 illustrated in FIG. 8, the electrical resistance of the probe 1 to electric signals propagating through the probe 1 can be reduced by disposing the transmission member 30 having the electrical resistance that is lower than the base material 20 on the side surface of the base material 20. For example, when Ni material is used for the base material 20, the electrical resistance of the probe 1 can be reduced by using Au material for the transmission member 30.

In other respects, the probe 1 according to the third embodiment is substantially the same as the first embodiment, and overlapping descriptions are omitted. For example, a convex portion may be formed on the first side surface 121 and a concave portion may be formed on the opposed side surface 201. Further, the abutting surface between the convex portion and the concave portion may be tapered, or multiple pairs of the convex portions and the concave portions may be formed.

### <Modified example>

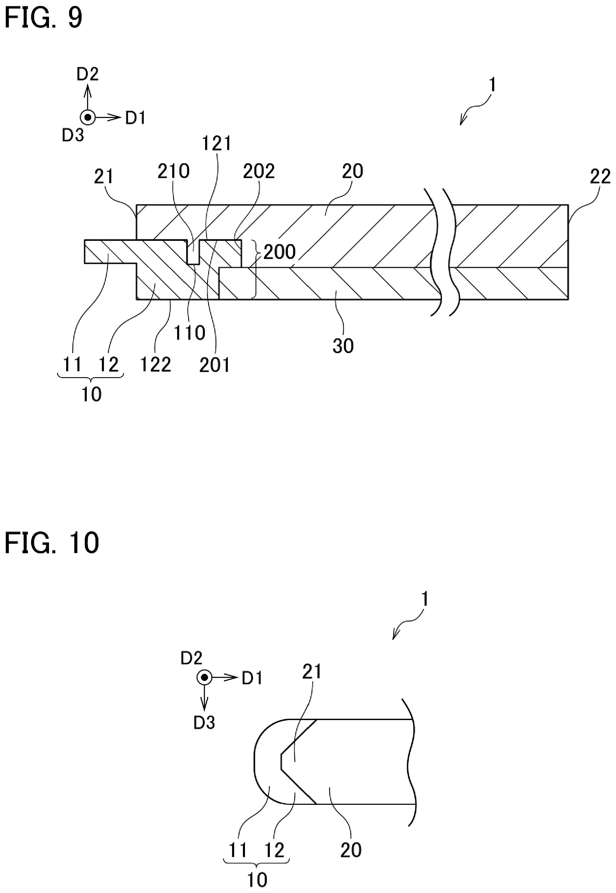

As in the modified example illustrated in FIG. 9, a portion of the transmission member 30 may extend in the direction in which the projection portion 11 projects along the axial direction D1 so as to overlap the joint region 200. In the probe 1 illustrated in FIG. 9, a portion of the support portion 12 of the tip member 10 is sandwiched between the transmission member 30 and the base material 20. In other words, a portion of the support portion 12 is disposed closer to the central axis side of the probe 1 than the transmission member 30. In the probe 1 illustrated in FIG. 9, the contact area between the tip member 10 and the transmission member 30 is larger than that of the probe 1 illustrated in FIG. 8, thereby making it possible to reduce the electrical resistance.

### (Other embodiments)

The embodiments of the present invention have been described as above, but the statements and drawings forming part of this disclosure should not be understood as limiting the invention. Various alternative embodiments, examples, and operating techniques will be apparent to those skilled in the art from this disclosure.

For example, as illustrated in FIG. 10, the end surface of the projection portion 11 in contact with the inspection object may be formed to have a curved surface. By forming the end surface of the projection portion 11 to have a curved surface, it is possible to prevent the inspection object from being damaged by bringing the projection portion 11 into contact with the inspection object.

In the above description, the case where the projection portion 11 of the tip member 10 projects from the first end portion 21 of the base material 20 and the projection portion 11 comes into contact with the inspection object 4 has been described. However, both the tip member 10 and the base material 20 may come into contact with the inspection object 4.

Thus, the present invention will of course include various embodiments and the like which are not described herein.

### REFERENCE SIGNS LIST

- 1: Probe
- 10: Tip member
- 11: Projection portion
- 12: Support portion
- 20: Base material
- 21: First end portion
- 22: Second end portion
- 30: Transmission member
- 110: Concave portion
- 121: First side surface
- 122: Second side surface
- 123: Embedded portion
- 200: Joint region
- 201: Opposed side surface
- 202: Opposed end surface
- 203: Embedded groove
- 210: Convex portion

## Claims

1. A probe used for inspecting the electrical characteristics of an inspection object, the probe comprising:
a tip member that has a support portion and is configured to be in contact with the inspection object; and
a base material in which a joint region is formed by retracting a portion of a side surface in a thickness direction perpendicular to an axial direction within a certain range along the axial direction from one end; wherein
a first side surface of the support portion of the tip member and a retracted side surface of the base material exposed in the joint region abut against each other, and the support portion is joined to the base material, and
a convex portion that projects in the thickness direction is formed on one of the first side surface and the retracted side surface, and a concave portion that fits with the convex portion is formed on the other of the first side surface and the retracted side surface.

2. The probe according to claim 1, wherein
the tip member has a projection portion that is coupled to the support portion and configured to be in contact with the inspection object,
an embedded portion extending in a direction opposite to a direction in which the projection portion projects is formed in the support portion of the tip member;
an embedded groove is formed in an opposed end surface of the base material that faces the support portion in the axial direction, and
the embedded portion is embedded in the embedded groove.

3. The probe according to claim 1, further comprising:
a transmission member made of a material having a lower electrical resistance than the base material, which is disposed on a side surface of the base material extending in the axial direction from an end of the joint region; wherein
the support portion of the tip member and the transmission member are connected to each other.

4. The probe according to claim 3, wherein
a portion of the transmission member extends along the axial direction so as to overlap the joint region, and
a portion of the support portion of the tip member is sandwiched between the extended portion of the transmission member and the base material.

5. The probe according to claim 1, wherein
a second side surface of the support portion that faces in the opposite direction of the first side surface is continuous with the base material without a step.

6. The probe according to any one of claims 1 to 5, wherein
a plurality of convex portions and a plurality of concave portions that respectively fit with the convex portions are formed on the first side surface and the retracted side surface.

7. The probe according to any one of claims 1 to 5, wherein
an abutting surface between the convex portion and the concave portion has a rectangular shape formed by sides parallel and perpendicular to the axial direction in a cross section along the axial direction.

8. The probe according to any one of claims 1 to 5, wherein
an abutting surface between the convex portion and the concave portion has a tapered shape formed by sides obliquely intersecting the axial direction in a cross section along the axial direction.

9. The probe according to any one of claims 1 to 5, wherein
in a direction in which the tip member in contact with the inspection object is displaced when starting to inspect the inspection object, the tip member and the base material are joined such that the support portion and the base material have an overlap, and a projection direction of the convex portion is a direction in which the tip member is displaced.
